# EUROPÄISCHE PATENTSCHRIFT

(11) **EP 1 917 666 B1**
(45) Veröffentlichungstag und Bekanntmachung des Hinweises auf die Patenterteilung: **15.02.2012**
(21) Anmeldenummer: 06776958.8
(22) Anmeldetag: 18.08.2006
(51) Int. Cl.: H01B 1/12, C08L 65/00, C08L 79/02, C08K 3/08, C08K 3/10

(54) **ZUSAMMENSETZUNG MIT INTRINSISCH LEITFÄHIGEM POLYMER ENTHALTEND INDIUM**
COMPOSITION COMPRISING AN INDIUM-CONTAINING INTRINSICALLY CONDUCTIVE POLYMER
COMPOSITION COMPRENANT UN POLYMERE INTRINSEQUEMENT CONDUCTEUR QUI CONTIENT DE L'INDIUM

(30) Priorität: 19.08.2005 DE 102005039608
(43) Veröffentlichungstag der Anmeldung: 07.05.2008
(73) Patentinhaber: Enthone, Inc., West Haven, CT 06516 (US)
(72) Erfinder: WESSLING, Bernhard, 22941 Bargteheide (DE)
(74) Vertreter: UEXKÜLL & STOLBERG
(86) Internationale Anmeldenummer: PCT/EP2006/008165
(87) Internationale Veröffentlichungsnummer: WO 2007/020100

(56) Entgegenhaltungen:
- EP-A1- 0 962 943
- WO-A-2004/029176
- ARICI E ET AL: "Hybrid solar cells based on inorganic nanoclusters and conjugated polymers" PREPARATION AND CHARACTERIZATION, ELSEVIER SEQUOIA, NL, Bd. 451-452, 22. März 2004 (2004-03-22), Seiten 612-618, XP004495174 ISSN: 0040-6090

## Beschreibung

Die Erfindung betrifft eine chemische Verbindung mit Gehalt an intrinsisch leitfähigem Polymer in dotierter Form, Verfahren zu deren Herstellung sowie die Verwendung dieser Verbindung zur Herstellung von elektronische Vorrichtungen und insbesondere die Verwendung als Lochinjektionsschicht in organischen Leuchtdioden, den sogenannten OLEDs.

Organische Leuchtdioden (OLEDs), besonders polymere organische Leuchtdiode (manchmal auch PLEDs genannt), erfreuen sich weltweiten Interesses. Von diesen erwartet der Markt neuartige leistungsfähige Displays, wobei vor allem PLEDs wegen der einfachen Herstellungsweise durch Spincoaten oder Inkjetdrucken und im Vergleich zu OLEDs aus niedermolekularen Stoffen einfacheren Schichtaufbaus eine große Zukunft vorhergesagt wird.

Üblicherweise besteht eine OLED aus einer Anode, einer sogenannten Lochinjektionsschicht, einer Schicht mit lichtemittierendem organischer Stoff und einer Kathode aus einem Metall mit niedriger Austrittsarbeit, wie Ca und Ba. Üblicherweise werden die OLEDs gekapselt, um einen zu schnellen Abbau der Leistung zu verhindern.

Monochrome Displays, die mit PLEDs in ausreichender Stabilität und Brillanz, z.B. unter Verwendung des Produktes "Super Yellow" der Covion GmbH, Frankfurt, hergestellt werden können, finden im Markt nicht genügend breite Akzeptanz. Jedoch lassen sich mit solchen Displays Unterschiede in der Qualität der Lochinjektionsschicht feststellen, die aus leitfähigen Polymeren gebildet wird. Diese Schicht ist erforderlich, weil das als Anode üblicherweise eingesetzte Indium-Zinn-Oxid (ITO) allein mit ca. -4,3 eV nicht das geeignete Niveau der Austrittsarbeit aufweist und zudem im Betrieb sehr schnell schwarze Punkte und Durchbrennen der OLEDs und PLEDs verursacht.

Hier hat sich als Standardmaterial mit Polystyrolsulfonsäure (PSSH) dotiertes PEDOT (Baytron P der Fa. H. C. Starck, Deutschland) etabliert, da durch dieses die Austrittsarbeit an der Anode auf das gewünschte Niveau von -5,0 bis 5,1 eV angehoben wird. In Kombination mit dem Leuchtstoff "Super Yellow" wird eine mehr als ausreichende Stabilität solcher Leuchtdioden erzielt. PEDOT-PSSH-Schichten werden üblicherweise aus wässriger Dispersion aufgebracht, z.B. mittels Spincoaten oder Inkjetdrucken. Versuche scheiterten jedoch, dies auch mit Polyanilin zu erreichen, welches ebenfalls mit PSSH dotiert war.

Auch wenn Lochinjektionsschichten, die aus Polyanilin gebildet wurden, nämlich PANI-PSSH, mit etwa -5,1 eV im Prinzip die gleiche Austrittsarbeit wie PEDOT-PSSH aufweisen, so zeigen diese im "Pulsbetrieb" eine unzureichende Stabilität und versagen teilweise bereits nach 0,5 Stunden. Beim Pulsbetrieb wird eine höhere Spannung als im Gleichstrombetrieb, jedoch nur für kurze Zeit angelegt. Demgegenüber erlaubt PEDOT-PSSH einen Dauerbetrieb von mehreren Hundert Stunden bei erhöhter Temperatur. Eine Erklärung für das so unterschiedliche Verhalten von PANI im Vergleich zu PEDOT wurde bislang nicht gefunden.

Beide Materialien konnten aber bisher nichts dazu beitragen, die für farbige Displays ("RGB") notwendige Stabilität der roten, grünen und besonders der blauen lichtemittierenden Polymeren zu verbessern. Auch bei OLEDs aus niedermolekularen Stoffen sind vor allem die blauen lichtemittierenden Stoffe der stabilitätsbegrenzende Faktor.

Es ist deshalb das Ziel zahlreicher Forschungsgruppen und Industrieunternehmen, einerseits die intrinsische Instabilität vor allem der blauen Lichtemitter zu überwinden, andererseits aber auch neuartige Lochinjektionsmaterialien zu entwickeln, die ebenfalls zur Stabilitätserhöhung beitragen.

Hierbei werden derzeit zwei Ansatzpunkte oder deren Kombination zur Problemlösung favorisiert:
1. Die Anhebung des Betrages der Austrittsarbeit auf mehr als 5,3 eV, da die Lochinjektion in das blaue Emittermaterial bei einer Austrittsarbeit von -5 bis -5,1 eV extrem erschwert ist, was als eine Ursache für die Instabilität angesehen wird, und
2. der Austausch von PSSH durch andere Dotierungsmittel, da man annimmt, dass deren Sulfonsäuregruppen zu einer Schädigung des Emittermaterials im Verlauf des Betriebes führen.

Beide Ansatzpunkte haben gewisse Fortschritte erbracht, die aber bei weitem noch nicht ausreichen.

EP 0 962 943 A1 offenbart ein leitfähiges Sol, das kolloidale sogenannte Primärteilchen mit einer Größe von 5 bis 50 nm aus leitfähigem Zinkantimonat oder Indiumantimonat oder einer Mischung davon und kolloidale Teilchen mit einer Primärteilchengröße von 2 bis 10 nm aus einem leitfähigen Polymer wie Polythiophen oder einem Derivat davon enthält. Dieses Verbundmaterial findet verschiedene Anwendungen wie z. B. als transparentes antistatisches Material.

E. Arici et al., "Hybrid Solar Cells based on Inorganic Nanoclusters and Conjugated Polymers", Thin Solid Films 451 - 452 (2004), 612 - 618 beschreiben Mischungen von halbleitenden Polymeren mit Kupfer-Indiumdiselenid-Nanokristallen für fotovoltaische Anwendungen.

Es besteht daher nach wie vor ein großer Bedarf an einer Zusammensetzung, mit deren Hilfe elektronische Vorrichtungen mit verbesserten Eigenschaften und insbesondere organische Leuchtdioden hergestellt werden können, denen die Zusammensetzung eine hohe Stabilität der RGB-Emitter, darunter besonders von Blau, verleiht.

Diese Aufgabe wird überraschenderweise durch die chemische Verbindung gemäß einem der Ansprüche 1 bis 4 gelöst.

Die erfindungsgemäße Zusammensetzung, zeichnet sich dadurch aus, dass sie mindestens ein intrinsisch leitfähiges Polymer und Indium enthält.

Überraschenderweise können mit einer solchen Zusammensetzung insbesondere organische Leuchtdioden, OLEDs und PLEDs, hergestellt werden, die hohe Stabilität und Lichtausbeute zeigen.

Unter intrinsisch leitfähigen Polymeren oder leitfähigen Polymeren, werden Stoffe verstanden, die aus niedermolekularen Verbindungen (Monomeren) aufgebaut sind, durch Polymerisation mindestens oligomer sind, also mindestens 3 Monomereinheiten enthalten, die durch chemische Bindung verknüpft sind, im neutralen (nicht leitfähigen) Zustand ein konjugiertes π-Elektronensystem aufweisen und durch Oxydation, Reduktion oder Protonierung (was oftmals als "dotieren" bezeichnet wird) in eine ionische Form überführt werden können, die leitfähig ist. Die Leitfähigkeit beträgt mindestens 10⁻⁷ S/cm und liegt üblicherweise unter 10⁹ S/cm.

Als Dotierungsmittel werden im Falle der Dotierung durch Oxidation z.B. Jod, Peroxide, Lewis- und Protonensäuren oder im Falle der Dotierung durch Reduktion z.B. Natrium, Kalium, Calcium eingesetzt.

Leitfähige Polymere können chemisch außerordentlich unterschiedlich zusammengesetzt sein. Als Monomere haben sich z.B. Acetylen, Benzol, Napthalin, Pyrrol, Anilin, Thiophen, Phenylensulfid, peri-Naphthalin und andere, sowie deren Derivate, wie Sulfo-Anilin, Ethylendioxythiophen, Thieno-thiophen und andere, sowie deren Alkyl- oder Alkoxy-Derivate oder Derivate mit anderen Seitengruppen, wie Sulfonat-, Phenyl- und andere Seitengruppen, bewährt. Es können auch Kombinationen der oben genannten Monomere als Monomer eingesetzt werden. Dabei werden z.B. Anilin und Phenylensulfid verknüpft und diese A-B-Dimere dann als Monomere eingesetzt. Je nach Zielsetzung können z.B. Pyrrol, Thiophen oder Alkylthiophene, Ethylendioxythiophen, Thieno-thiophen, Anilin, Phenylensulfid und andere miteinander zu A-B-Strukturen verbunden und diese dann zu Oligomeren oder Polymeren umgesetzt werden.

Die meisten leitfähigen Polymere weisen einen mehr oder weniger starken Anstieg der Leitfähigkeit mit steigender Temperatur auf, was sie als nicht-metallische Leiter ausweist. Andere leitfähige Polymere zeigen zumindest in einem Temperaturbereich nahe Raumtemperatur ein metallisches Verhalten insofern, als die Leitfähigkeit mit steigender Temperatur sinkt. Eine weitere Methode, metallisches Verhalten zu erkennen, besteht in der Auftragung der sogenannten "reduzierten Aktivierungsenergie" der Leitfähigkeit gegen die Temperatur bei niedrigen Temperaturen (bis nahe 0 K). Leiter mit einem metallischen Beitrag zur Leitfähigkeit zeigen eine positive Steigung der Kurve bei niedriger Temperatur. Solche Stoffe bezeichnet man als "organische Metalle".

intrinsisch leitfähige Polymere sind Polyanilin (PAni), Polythiophen (PTh), Poly (3, 4-ethylendioxythiophen) (PEDT), Polypyrrol (PPy) sowie deren Derivate (die z.B. aus mit Seitenketten oder -gruppen substituierten Monomeren gebildet werden), deren Copolymere und deren physikalische Mischungen. Besonders bevorzugt sind Polyanilin (PAni), Polythiophen (PTh), Polypyrrol. (PPy), Pol(3,4-ethylendioxythiophene) (PEDT), Polythieno-thiophen (PTT) und deren Derivate sowie Mischungen davon.

Einen guten Überblick über bereits synthetisierte intrinsisch leitfähige Polymere, die erfindungsgemäß geeignet sind, findet man in Synthetic Metals, Hefte 17, 18 und 19 (1987) sowie Vol. 84-96 (1997).

Die erfindungsgemäße Verbindung enthält Polyanilin, Polythiophen, Polypyrrol oder Derivate von diesen als intrinsisch leitfähiges Polymer. Mischungen sind ebenfalls möglich. Dabei sind Polyanilin , Polythiophen oder Derivate davon und insbesondere Polyanilin (PANI), Polypyrrol (Ppy), Polythieno-thiophen (PTT) und Poly(3,4-ethylendioxy-2,5-thiophen (PEDOT) besonders bevorzugt. Letzteres ist unter der Bezeichnung Baytron im Handel erhältlich. In der erfindungsgemäßen Verbindung liegt das intrinsisch leitfähige Polymer in dotierter Form vor. Als Dotierungsmittel kommen niedermolekulare und insbesondere polymergebundene Dotierungsmittel in Frage. Bevorzugt ist das leitfähige Polymer mit Polystyrolsulfonsäure (PSSH4), Polyfluorsulfonsäure-co-tetrafluorethylen (unter der Bezeichnung Nafion im Handel erhältlich), Poly(vinylsulfonsäure) und (Poly(2-acrylamido-2-methyl-propansulfonsäure) (PAMPSA) dotiert, wobei die beiden zuerst genannten besonders bevorzugt sind.

Die Verbindung liegt üblicherweise als Feststoff, änsbesondere als ein Pulver vor. Es ist jedoch bevorzugt, dass die Verbindung als Lösung oder Dispersion vorliegt. Diese bieten erhebliche Vorteile bei der Anwendung und insbesondere der Verwendung zur Herstellung von elektronischen Vorrichtungen.

Erfindungsgemäß wird überraschenderweise eine chemische Verbindung von intrinsisch leitfähigem Polymer in dotierter Form mit Indium gebildet. Mit Hilfe von bekannten Analysenvertahren kann der Fachmann die Bedingungen und den Verlauf der Reaktion der eingesetzten Materialen zur Bildung der erfindungsgemäßen Verbindung in gewünschter Weise steuern.

Als geeignete Technik zum Nachweis der Bildung einer chemischen Verbindung ist insbesondere die Cyclovoltammetrie genutzt worden. Mit ihr konnte die Bildung einer Verbindung zwischen Indium und Polyanilin nachgewiesen werden, und diese Verbindung bildet eine bevorzugte Ausführungsform der Erfindung. Eine weitere Technik, mit der der Nachweis der Bildung einer chemischen Verbindung zwischen Indium und Polyanilin gelang, ist die UV/Vis-Spektroskopie.

Die Art der chemischen Bindung zwischen Indium und Polymer konnte bisher nicht aufgeklärt werden. Es könnte sich allerdings möglicherweise um eine Komplexbindung handeln.

Die erfindungsgemäße Verbindung wird durch ein Verfahren hergestellt, bei dem intrinsisch leitfähiges Polymer mit Indium in Gegenwart eines Dispersions- oder Lösungsmittels in Kontakt gebracht wird.

Dabei wird das intrinsisch leitfähige Polymer in dotierter Form mit elementarem Indium in Kontakt gebracht. Hierbei ist es möglich, dass das Polymer bereits in dispergierter Form vorliegt.

Üblicherweise wird das Verfahren in der Weise durchgeführt, dass nach der abgeschlossenen Synthese des leitfähigen Polymers, wie sie z.B. in EP 329 768 offenbart ist, Indium-Metall oder Indium-Salz der Syntheselösung zugesetzt wird. Nach Bildung der chemischen Verbindung wird dann aufgearbeitet und das erhaltene Material in der Regel dispergiert.

Weiter ist ebenfalls ein Verfahren bevorzugt, bei dem die Herstellung des intrinsisch leitfähigen Polymers in Gegenwart von elementarem Indium erfolgt. Bei diese Ausführungsform wird in der Regel Indium in der ausgewählten Form der Mischung der Edukte zugesetzt, deren Reaktion dann zum gewünschten Polymer führt.

Weiter ist ein erfindungsgemäßes Verfahren bevorzugt, bei dem die Verbindung dispergiert wird. Als Dispersionsmittel kommen dabei vornehmlich wässrige oder organische Dispersionsmittel in Frage.

Das Verfahren dient zur Herstellung von Verbindungen zwischen Polyanilin und Indium, wobei insbesondere zusätzlich Dotierungsmittel wie PSSH und/oder Polyfluorsulfonsäure-co-tetrafluorethylen vorhanden sind.

In Fällen, in denen chemische Verbindungen gebildet wurden und nicht einfach physikalische Mischungen von leitfähigen Polymeren mit Indiumionen, konnte dies durch Cyclovoltammetrie nachgewiesen werden. Dadurch dass sich das Normalpotential des leitfähigen Polymeren, und besonders des bevorzugten Polyanilins, deutlich verschoben hat, ist die Bildung einer neuen Verbindung erkennbar. Weiterhin wurde in diesen Fällen die Verschiebung eines Absorptionspeaks im UV/Vis-Spektrum beobachtet.

Die erfindungsgemäßen chemischen Verbindungen von Polymer und Indium erlauben überraschenderweise die Herstellung von elektronischen Vorrichtungen mit attraktiven Eigenschaften.

Die Erfindung betrifft daher ebenfalls eine elektronische Vorrichtung, die die erfindungsgemäße Verbindung enthält.

Dabei ist eine Vorrichtung bevorzugt, die eine Leuchtdiode und insbesondere eine organische Leuchtdiode OLED ist.

Die Vorrichtung enthält vorzugsweise die Verbindung in einer Schicht zwischen den Elektroden der Leuchtdiode.

Eine solche Schicht ist insbesondere die sogenannte Lochinjektionsschicht, die auch als Ladungsinjektions- oder Pufferschicht bezeichnet wird. Sie ist üblicherweise auf der Anode der Diode aufgebracht.

Somit ist weiter eine Vorrichtung bevorzugt, bei der die Verbindung in der Lochinjektionsschicht vorhanden ist und insbesondere diese bildet.

Überraschenderweise ermöglichen Lochinjektionsschichten, die die erfindungsgemäße Verbindung enthalten und insbesondere aus ihr gebildet sind, insbesondere eine chemische Verbindung zwischen leitfähigen Polymeren und Indium, bevorzugt zwischen Polyanilin und Indium, in Verbindung mit herkömmlichen Polymeren als Emitterschicht oder lichtemittierende Schicht, wie Super Yellow, sogar im Pulsbetrieb eine sehr hohe Stabilität der OLED.

Noch überraschender ist die drastische Steigerung der Stabilität und Lichtausbeute in OLEDs mit blauen lichtemittierenden Polymeren. So ist es mittels der erfindungsgemäßen Zusammensetzung möglich, OLEDs herzustellen, die keine Elektronensperrschicht zwischen Lochinjektionschicht und Emitterschicht aufweisen.

Ohne eine solche Sperrschicht konnten bisher blau emittierende OLEDs nicht betrieben werden, auch nicht bei Einsatz von PEDOT-PSSH, PAni-Polyfluorsulfonsäure-co-tetrafluorethylen, PTT-PSSH oder PTT-Polyfluorsulfonsäure-co-tetrafluorethylen als Lochinjektionssehicht. Bei allen diesen Materialien sank die Lichtausbeute bereits nach kurzer Zeit.

Mithilfe der erfindungsgemäßen Verbindung ist es erstmalig bei einem bestimmten blauen Emitter möglich geworden, eine OLED ohne eine Sperrschicht mit immerhin einer Lebensdauer von über 10 Stunden zu betreiben. Bisher konnte dieser Emitter ohne Sperrschicht praktisch nicht bei OLEDs verwendet werden. Bei einem anderen Emitter führte trotz fehlender Sperrschicht der Einsatz der erfindungsgemäßen Verbindung zu einer Steigerung der Lebensdauer auf über 150 Stunden. Eine entsprechende OLED, in der PEDOT als Lochinjektionsschicht eingesetzt wurde, zeigte hingegen lediglich eine Lebensdauer von weniger als 100 Stunden.

Die günstigen Auswirkungen der erfindungsgemäßen Verbindung insbesondere bei OLEDs auf deren Stabilität ist auch deshalb überraschend, weil bisher angenommen wurde, dass Schichten in OLEDs keinerlei Verunreinigungen insbesondere metallischer Art aufweise dürfen. Aus diesem Grunde wurden die zur Herstellung von Lochinjektionsschichten eingesetzten Dispersionen stets sehr aufwendig gereinigt. Es ist überdies überraschend, dass die erfindungsgemäße Verbindung diese Eigenschaften auch bei Dotierung des Polymers mit aromatischen Sulfosäuren hat, obwohl gerade diesen Säuren eine destabilisierende Wirkung zugeschrieben wird.

Versuche mit anderen (Polyanilin)-Verbindungen, z.B. mit Fe oder Cu, führten jedoch zu keiner Verbesserung der Stabilität, sondern wie im Falle von Verbindungen mit Silber eher zu Verschlechterung der Eigenschaften der OLEDs.

Die Erfindung betrifft somit auch ein Verfahren zur Herstellung von elektronischen Vorrichtungen, bei dem die erfindungsgemäße Verbindung verwendet wird.

Sie betrifft ebenfalls die Verwendung der Verbindung zur Herstellung von elektronischen Vorrichtungen, und insbesondere eine solche Verwendung, bei der die Verbindung als Schicht zwischen den Elektroden einer Leuchtdiode und insbesondere als Lochinjektionsschicht eingesetzt wird.

Die Erfindung wird im folgenden anhand von Beispielen näher erläutert.

### Beispiele

### Beispiel 1 -Polyanilin-PSSH-Pulver

Zunächst wurde Polyanilin-Pulver nach dem in EP 329 768 beschrieben Verfahren hergestellt. Es wurde PANI-PSSH (Monomerzu Sulfonsäuregruppenverhältnis 1:1,5) erzeugt, indem 1010 g einer 30%igen Polystyrolsulfonsäurelösung (PSSH) und 89 ml Anilin in 4190 g deionisiertem Wasser in einem Doppelwandreaktor gegeben und die Lösung mittels Kryostat und Kühlmedium auf 1°C gekühlt wurde. Zu dieser Lösung wurde eine Lösung von 280 g Ammoniumperoxodisulfat (APS) in 420 ml deionisiertem Wasser so langsam zugetropft, dass die Temperatur nicht über 5°C anstieg. Der erhaltene Feststoff wurde mit Aceton gefällt, filtriert, mit Aceton gewaschen und getrocknet.

### Beispiel 2 - Polyanilin-PSSH-Indium-Pulver Typ__B

In zu Beispiel 1 analoger Weise wurden 73,9 g PSSH, 7,44 ml Anilin, und 944 mg Indium-Granalien in 48,6 ml deionisiertem Wasser vorgelegt und mit 24 g APS zur Reaktion gebracht. Vor der weiteren Aufarbeitung wurden nicht abreagierte Indium-Granalien-Reste abgetrennt. Der verbleibende Feststoff wurde gewaschen und getrocknet, und es verblieb ein Rückstand von 685 mg.

### Beispiel 3

### Polyanilin-PSSH-Indium-Pulver Typ C

In zu Beispiel 1 analoger Weise wurden 73,9 g PSSH, 7,44 ml Anilin in 48,6 ml deionisiertem Wasser vorgelegt und mit 24 g APS zu Reaktion gebracht. Nach Abschluss der Reaktion wurden 985 mg Indium-Granalien in die Reaktionsmischung eingebracht, und es wurde 22 Stunden gerührt. Vor der weitere Aufarbeitung wurden nicht abreagierte Indium-Granalien-Reste abgetrennt. Der verbleibende Feststoff wurde gewaschen und getrocknet, und es verblieb ein Rückstand von 610 mg.

### Beispiel 4

### Dispersion eines Pulvers in Wasser

Zunächst wurde die Restfeuchte des Pulvers (nach Beispiel 1-3) bestimmt, um eine korrekte Einwaage bestimmen zu können. Dann wurden 16 g Pulver (aus Beispiel 1, 2 oder 3 ) in 500 ml deionisiertes Wasser gegeben und im Ultraturrax bei einer Drehzahl von 10.000 rpm 1,5 Stunden dispergiert.

Die erhaltenen Dispersionen wurden dann mit Ultraschall nachdispergiert, indem das Gefäß unter Kühlung mit Wasser 30 min mit Ultraschall (Sonotrode mit 1 kw Leistung) beschallt wurde.

Die Dispersionen zeigten Partikelgrößenwerte von 40-80 mm (Zahlenmittel), gemessen mittels Laser-Doppel-Methode.

Die Dispersion konnten schließlich, sofern gewünscht, noch mittels Ionenaustausch auf übliche Weise gereinigt werden.

### Beispiel 5

### Herstellung einer Dispersion mit anschließende Bildung der Indium-Zusammensetzung, Typ 2

Es wurde gemäß Beispiel 5 eine Dispersion (120 g) mit Pulver aus Beispiel 1 hergestellt. Diese Dispersion wurde mit 650 mg Indium-Granalien versetzt und 72 Stunden berührt. Anschließens wurde über Schwarzbandfilter filtriert. Das im Filter verbleibende Indium wurde mit deionisiertem Wasser gewaschen und getrocknet. Es verblieben 563 mg Indium. Die Dispersion enthielt somit 0,72 mg Indium pro Gramm Dispersion.

### Beispiel 6

### Herstellung einer Dispersion mit anschließender Bildung der Indium-Zusammensetzung, Typ 3

Es wurde gemäß Beispiel 5 eine Dispersion (100 g) mit Pulver aus Beispiel 1 hergestellt. Diese Dispersion wurde mit 20 g einer 15%igen Perfluorsulfonsäure-co-tertafluorethylen-Lösung in Wasser (Liquion Solution LQ-1115, 110 EW) versetzt und 20 min gerührt. Die erhaltene Dispersion wurde anschließend wie in Beispiel 5 weiter verarbeitet.

### Beispiel 7

### Zusammensetzungen von Polypyrrol mit Indium

Zur Herstellung entsprechender erfindungsgemäßer Zusammensetzungen mit Polypyrrol wurde die Beispiel 1-4 und 5 und 6 analog nachgearbeitet, wobei statt PANI als intrinsisch leitfähiges Polypyrrol (PPy) eingesetzt wurde.

### Beispiel 8

### Zusammensetzungen von PEDOT mit Indium

Zur Herstellung entsprechender Zusammensetzungen mit PEDOT wurde analog zu den Beispielen 5 und 6 gearbeitet und statt PANI als intrinsisch leitfähiges Polymer PEDOT in Form des Handelsproduktes Baytron P AI-4083 eingesetzt.

## Patentansprüche

1. Chemische Verbindung von intrinsisch leitfähigem Polymer in dotierter Form und Indium, wobei das leitfähige Polymer ausgewählt ist aus Polyanilin, Polythiophen, Polypyrrol oder Derivaten von diesen.

2. Chemische Verbindung nach Anspruch 1, die Poly(3,4-ethylendioxy-2,5-thiophen), Polyanilin oder Polythienothiophen als intrinsisch leitfähiges Polymer enthält.

3. Chemische Verbindung nach Anspruch 1 oder 2, bei der das intrinsisch leitfähige Polymer mit Polystyrolsulfonsäure oder Polyfluorsulfonsäure-co-tetrafluorethylen dotiert ist.

4. chemische Verbindung nach einem der Ansprüche 1 bis 3, die eine chemische Verbindung von Polyanilin und Indium ist.

5. Zusammensetzung, die eine chemische Verbindung nach einem der Ansprüche 1 bis 4 enthält.

6. Zusammensetzung nach Anspruch 5, die als Lösung oder Dispersion vorliegt.

7. Verfahren zur Herstellung der chemischen Verbindung nach einem der Ansprüche 1 bis 4 oder der Zusammensetzung nach einem der Ansprüche 5 oder 6, bei dem intrinsisch leitfähiges Polymer in dotierter Form mit elementarem Indium in Gegenwart eines Dispersions- oder Lösungsmittels in Kontakt gebracht wird.

8. Verfahren nach Anspruch 7, bei dem die chemische Verbindung oder die zusammensetzung dispergiert wird.

9. Verwendung der chemischen Verbindung nach einem der Ansprüche 1 bis 4 oder der Zusammensetzung nach einem der Ansprüche 5 oder 6 zur Herstellung von elektronischen Vorrichtungen.

10. Verwendung nach Anspruch 9, bei der die chemische Verbindung oder die Zusammensetzung als Schicht zwischen den Elektroden einer Leuchtdiode und insbesondere als Lochinjektionsschicht eingesetzt wird.

## Claims

1. Chemical compound of intrinsically conductive polymer in doped form and indium, wherein the conductive polymer is selected from polyaniline, polythiophene, polypyrrole or derivatives of these.

2. Chemical compound according to claim 1 comprising poly(3,4-ethylenedioxy-2,5-thiophene), polyaniline or polythienothiophene as intrinsically conductive polymer.

3. Chemical compound according to claim 1 or claim 2, wherein the intrinsically conductive polymer is doped with polystyrene sulphonic acid or polyfluorosulphonic acid co-tetrafluoroethylene.

4. Chemical compound according to any one of claims 1 to 3, which is a chemical compound of polyaniline and indium.

5. Composition comprising a chemical compound according to any one of claims 1 to 4.

6. Composition according to claim 5, which is present as a solution or dispersion.

7. Process for the preparation of the chemical compound according to any one of claims 1 to 4 or of the composition according to any one of claims 5 or 6, wherein intrinsically conductive polymer in doped form is contacted with elemental indium in the presence of a dispersant or solvent.

8. Process according to claim 7, wherein the chemical compound or the composition is dispersed.

9. Use of the chemical compound according to any one of claims 1 to 4 or of the composition according to any one of claims 5 or 6 for the manufacture of electronic devices.

10. Use according to claim 9, wherein the chemical compound or the composition is used as a layer between the electrodes of a light-emitting diode and in particular as a hole-injection layer.

## Revendications

1. Composé chimique d'un polymère intrinsèquement conducteur sous forme dopée et d'indium, le polymère conducteur étant choisi dans le groupe comprenant la polyaniline, le polythiophène, le polypyrrole ou les dérivés de ceux-ci.

2. Composé chimique selon la revendication 1, qui contient du poly(3,4-éthylènedioxy-2,5-thiophène), de la polyaniline ou du polythiénothiophène en tant que polymère intrinsèquement conducteur.

3. Composé chimique selon la revendication 1 ou 2, dans lequel le polymère intrinsèquement conducteur est dopé avec de l'acide polystyrène sulfonique ou de l'acide polyfluoro-sulfonique-co-tétrafluoroéthylène.

4. Composé chimique selon l'une des revendications 1 à 3, qui est un composé chimique de polyaniline et d'indium.

5. Composition qui contient un composé chimique selon l'une des revendications 1 à 4.

6. Composition selon la revendication 5 qui se présente sous forme de solution ou de dispersion.

7. Procédé de fabrication du composé chimique selon l'une des revendications 1 à 4 ou de la composition selon l'une des revendications 5 ou 6, dans lequel un polymère intrinsèquement conducteur sous forme dopée est mis en contact avec de l'indium élémentaire en présence d'un agent de dispersion ou d'un solvant.

8. Procédé selon la revendication 7, dans lequel le composé chimique ou la composition est à l'état dispersé.

9. Utilisation du composé chimique selon l'une des revendications 1 à 4 ou de la composition selon l'une des revendications 5 ou 6 pour la fabrication de dispositifs électroniques.

10. Utilisation selon la revendication 9, dans laquelle le composé chimique ou la composition est employé en tant que couche entre les électrodes d'une diode électroluminescente et en particulier en tant que couche d'injection de trous.
